# EUROPEAN PATENT APPLICATION

(11) **EP 3 040 846 A1**
(43) Date of publication of application: **06.07.2016**
(21) Application number: 13892169.7
(22) Date of filing: 06.09.2013
(51) Int. Cl.: G06F 3/12, G06F 3/14

(54) **PRINTING SYSTEM USING DIGITAL PAPER AND METHOD FOR PRODUCING SAID DIGITAL PAPER**

(30) Priority: 26.08.2013 KR 20130101329
(71) Applicant: Industry-Academy Cooperation Corps. Of Sunchon National University, Jeollanam-do 540-742 (KR)
(72) Inventor: CHO, Gyou-jin, Suncheon-si Jeollanam-do 540-700 (KR)
(74) Representative: Beck & Rössig European Patent Attorneys
(86) International application number: PCT/KR2013/008089
(87) International publication number: WO 2015/030288

(57) **Abstract**

The present invention relates to a printing system using digital paper and a method for manufacturing the digital paper, and more particularly, to a technology for easily printing, on digital paper, an image or a document displayed on an IT device such as a smartphone, a tablet PC, a PC, or the like within one to two seconds without a printer using an NFC technology. A printing system using digital paper according to an embodiment of the present invention includes digital paper enabling printing thereon, an IT device configured to transmit, by wire or wirelessly, a command for printing information which is stored therein or being processed and the information to be printed, and an output module provided with a contact electrode for transmitting data to the digital paper and configured to receive, by wire or wirelessly, the command and the information to be printed transmitted from the IT device, convert the information to be printed into an image to be printed, and output the image to be printed to the digital paper.

## Description

### TECHNICAL FIELD

The present invention relates to a printing system using digital paper and a method for manufacturing the digital paper, and more particularly, to a technology for easily printing, on digital paper, an image or a document displayed on an information technology (IT) device such as a smartphone, a tablet PC, a PC, or the like within one to two seconds without a printer using an NFC technology.

### BACKGROUND ART

Digital paper referred to as electronic paper, smart paper, or electronic ink has recently been developed as a recording medium of a digital era and is replacing paper.

This digital paper is hardly restricted in terms of time and space and facilitates displaying and reading, and is thus called a dream display. Since this digital paper is free from temporal or spatial restraint due to the necessity of power supply, this digital paper is receiving attention in a situation requiring media for displaying a large amount of information from the Internet without restriction.

Such digital paper is a display device for displaying a text or an image which includes a thin flexible substrate such as a plastic substrate in which several millions of beads are scattered in oil holes, and can be reused several million times.

Furthermore, compared to a conventional flat display panel, the digital paper is produced at a low cost, and does not require continuous recharging or backlight like a liquid crystal screen, and thus can be driven with a very small amount of energy, thereby giving excellent energy efficiency.

Moreover, the digital paper is very clear, provides a wide viewing angle, and has a memory function which prevents letters from disappearing even if there is no power supply. Therefore, the digital paper can be widely used in public bulletin boards, advertisements, electronic books, etc.

In addition, the digital paper is based on an electrophoresis phenomenon in which an electromagnetic field is applied to a conductive material to impart mobility thereto, so that the digital paper disperses conductive microparticles or toner particles between thin flexible substrates and then presents data by virtue of a change in arrangement of the microparticles due to a polarity change of the electromagnetic field.

Meanwhile, ubiquitous represents an IT environment or a paradigm thereof in which a network can be freely accessed regardless of time, place, or computer or network conditions. With the arrival of a ubiquitous era, the scale and scope of IT industry increase as IT is more widely used in various spaces such as vehicles, homes, outdoor places, etc. and the number of users of computers or mobile devices connected to networks increases.

With the arrival of the ubiquitous era, it is required to develop a manufacturing technology for outputting and printing information on the digital paper in any place without a printer and for supplying the digital paper at a low price.

### DISCLOSURE OF THE INVENTION

### TECHNICAL PROBLEM

An object of the present invention, which has been proposed to solve the above-mentioned problems, is to provide a printing system using digital paper and a method for manufacturing the digital paper, according to which digital paper may be supplied at a low cost so that image or document information of an IT device such as a smartphone, a tablet PC, a PC, or the like is output to the digital paper so as to be used like a paper-printed material, and information is received by wire or through NFC so as to be directly output to the digital paper.

### TECHNICAL SOLUTION

A printing system using digital paper according to an embodiment of the present invention for achieving the above-mentioned object includes: digital paper enabling printing thereon; an information technology (IT) device configured to transmit, by wire or wirelessly, a command for printing information which is stored therein or being processed and the information to be printed; and an output module provided with a contact electrode for transmitting data to the digital paper and configured to receive, by wire or wirelessly, a printing command and the information to be printed transmitted from the IT device, convert the information to be printed into an image to be printed, and output the image to be printed to the digital paper.

The IT device may transmit, to the output module, the printing command and the information to be printed using wireless near field communication (NFC).

The output module may be shaped like a clip or tongs so that the digital paper is not moved when printing is performed through the digital paper.

Tongs parts of the output module may face other so that center parts of the tongs parts are outwardly curved and end portions of the tongs parts are opened or closed.

The output module may be provided with a secondary battery charged with voltage by wire or wirelessly from the IT device or an external device so as to supply the voltage to the output module.

The output module may be provided with a rectifier for rectifying power supplied from the outside and for supplying rectified power to the output module.

The digital paper may include: a thin film transistor (TFT) backplane disposed on a paper or plastic substrate; and electrophoretic ink (E-ink), an electrochromic display, or an organic light-emitting diode (OLED) laminated to the TFT backplane.

The TFT backplane may have a size of 100 to 10,000 pixels.

A method for manufacturing digital paper according to an embodiment of the present invention includes the steps of: (a) forming, on a paper or plastic substrate, a thin film transistor (TFT) backplane with a size of 100 to 10,000 pixels; and (b) laminating the TFT backplane to electrophoretic ink (E-ink), an electrochromic display, or an organic light-emitting diode (OLED) through an roll-to-roll continuous process.

In the step (a), the TFT backplane may be formed using a photolithography process or a deposition process.

In the step (a), the TFT backplane may be formed using a photolithography process and a printing process in combination.

In the step (a), the TFT backplane may be formed using a printing process.

The printing process may use at least one of printing techniques of inkjet, roll-to-roll (R2R) gravure, R2R offset, R2R reverse offset, R2R gravure offset, roll-to-plate (R2P) gravure, R2P offset, R2P reverse offset, and R2P gravure offset.

The printing process may use an R2R gravure printing technique.

Ink used for the printing process may be conductive ink, dielectric ink, or semiconductor ink.

In the step (a), the TFT backplane may be formed using a micro contact printing technique.

In the step (a), the TFT backplane may be formed using a photolithography process, a printing process, and a micro contact printing process in combination.

In the step (a), a contact electrode for exchanging data with the outside may be formed at the TFT backplane, wherein a lower layer of the contact electrode may be formed by etching a silver, copper or aluminum thin film and an upper layer of the contact electrode may be treated with graphite.

In the step (a), a contact electrode for exchanging data with the outside may be formed at the TFT backplane, wherein a lower layer of the contact electrode may be printed using silver, copper or aluminum ink and an upper layer of the contact electrode may be printed with graphite ink.

When the contact electrode is formed, any one of printing techniques of inkjet, R2R gravure, R2P gravure, R2R offset, R2P offset, screen, and rotary screen may be used.

In the step (b), an adhesive material used for the laminating may be thermosetting or UV-curable epoxy resin or cyanate-based resin.

In the step (b), the laminating may be performed such that one sheet of the TFT backplane and one sheet of the E-ink are overlapped by 1 µm.

### ADVANTAGEOUS EFFECTS

According to the above-mentioned solution, digital paper may be supplied at a low cost so that image or document information of an IT device such as a smartphone, a tablet PC, a PC, or the like is output to the digital paper so as to be used like a paper-printed material, and image or document information of a smartphone, a tablet PC, or the like, which enables information to be received by wire or through NFC and directly output to the digital paper, may be output to the digital paper, and, in particular, information of a mobile device may be printed with ease by anybody in any place without a printer.

### BRIEF DESCRIPTION OF THE DRAWINGS

Fig. 1 is a schematic diagram illustrating an output module applied to a printing system according to an embodiment of the present invention.
Fig. 2 is a diagram illustrating an internal configuration of the output module of Fig. 1.
Figs. 3 and 4 are conceptual diagrams illustrating a printing operation using digital paper according to an embodiment of the present invention.
Fig. 5 is an image illustrating an actual printing operation using digital paper according to an embodiment of the present invention.
Fig. 6 is a diagram illustrating a TFT backplane layout and a TFT of the digital paper of Fig. 5.
Fig. 7 is a diagram illustrating a printing process for manufacturing a TFT backplane during a manufacturing process of digital paper.
Fig. 8 is a diagram illustrating a laminating process for manufacturing digital paper during a digital paper manufacturing process.

### MODE FOR CARRYING OUT THE INVENTION

Hereinafter, configurations and operations of embodiments of the present invention will be described in detail with reference to the accompanying drawings.

It should be understood that the same reference numerals or signs denote the same elements even if those elements are illustrated in different figures.

Detailed descriptions of well-known relevant functions or configurations will be omitted in order not to unnecessarily obscure the focus of the present invention.

When it is mentioned that a certain part "includes" or "comprises" certain elements, the part may further include other elements, unless otherwise specified.

### <Printing System>

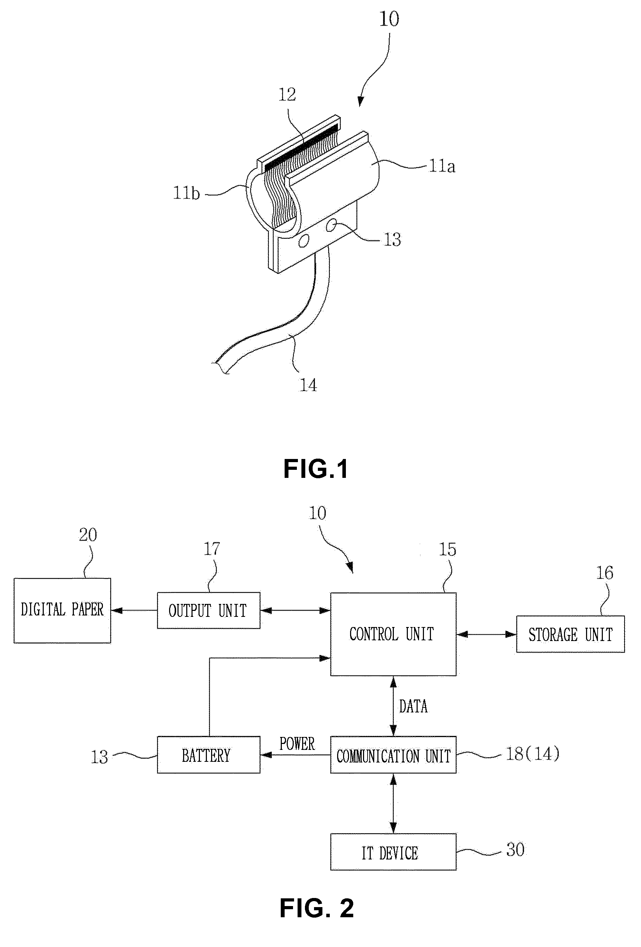

Fig. 1 is a schematic diagram illustrating an output module applied to a printing system according to an embodiment of the present invention.

An IT device described below includes a PC, a smartphone, a laptop computer, a tablet PC, etc.

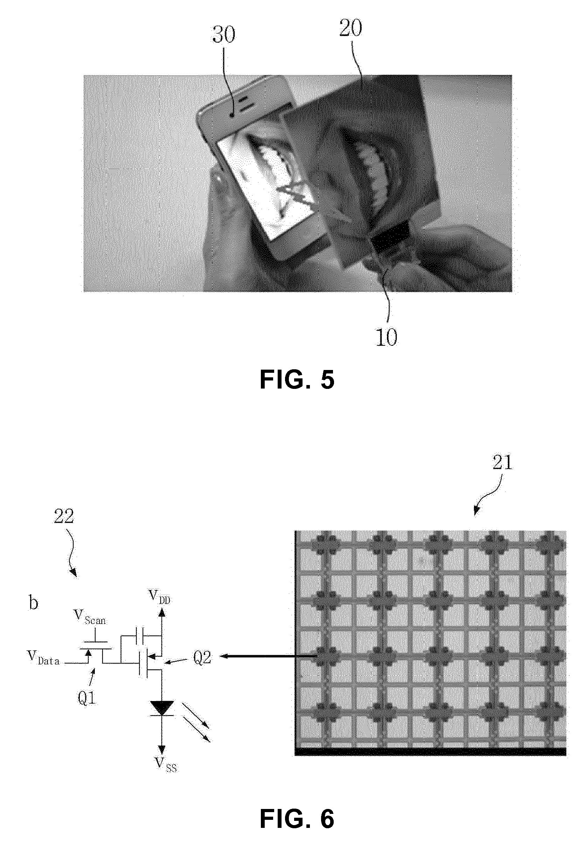

As illustrated in Figs. 1 and 6, an output module 10 is shaped like a clip or tongs so that digital paper 20 is fixed when printing is performed through the digital paper 20.

That is, since end portions of tongs parts 11a and 11b which face each other are configured to be closed or opened so that the output module 10 is normally closed but is spread and opened by an external force of a user.

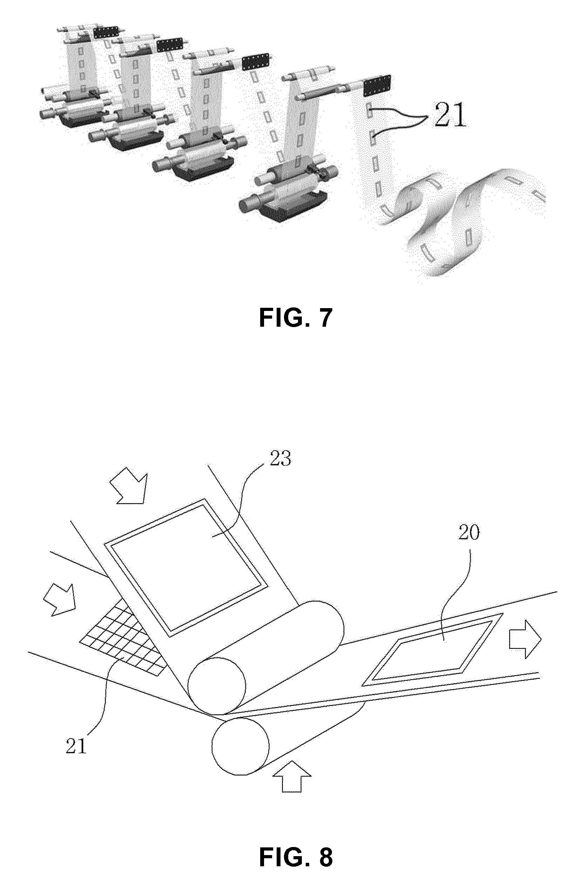

As illustrated in Figs. 1 and 7, a contact electrode 12 is disposed on a one-side end portion of the tongs part 11b so as to contact and be connected to a contact electrode (not shown) disposed on one side of a thin film transistor (TFT) backplane provided to the digital paper 20 when printing is performed through the digital paper 20.

Center portions of the tongs parts 11a and 11b are outwardly curved so that an accommodating part is formed inside the tongs parts 11a and 11b, and a non-shown means (e.g., a spring, a hinge shaft, a pressing part, or the like) is provided to an opposite side to the end portions of the tongs parts 11a and 11b so as to be used to manipulate the tongs parts 11a and 11b to close or open the end portions of the tongs parts 11a and 11b.

Furthermore, the opposite side to the end portions of the tongs parts 11a and 11b is further provided with a battery 13 for supplying power to the output module 10 and a control unit 15, a communication unit 18 (including a cable 14 for a wired connection to an IT device 30), and a storage unit 16 described below with reference to Fig. 2.

The battery 13 is a secondary battery such as a secondary lithium (Li) battery which is rechargeable through the communication unit 18.

The output module 10 may have dimensions of 3x3x2 cm³ or smaller so as to be easy to carry, but is not limited in size.

Fig. 2 is a diagram illustrating an internal configuration of the output module of Fig. 1.

As illustrated in Fig. 2, the output module 10 includes the storage unit 16, the communication unit 18, an output unit 17, the control unit 15, and the battery 13.

A volatile memory may be mainly used as the storage unit 16, but a nonvolatile memory may also be used as the storage unit 16. The communication unit 18 for exchanging data with the IT device 30 may employ wired communications or wireless communications, particularly, near field communication (NFC) of 13.56 MHz band. For the wired communications, a wired LAN or a USB may be used so that communication and charging may be performed simultaneously.

For the wireless communications, a wireless LAN, Bluetooth, ZigBee, or the like may be used.

The output unit 17, which includes the contact electrode 12 of Fig. 1, is connected to the digital paper 20.

The communication unit 18 receives, from the IT device 30, information to be printed and transfers the information to the control unit 15, and the control unit 15 converts the information to be printed into an image to be printed and outputs it to the digital paper 20 through the output unit 17.

Here, information transmission and issuing an output command for printing are performed by the IT device 30, and the control unit 15 simply executes an output-related command from the IT device 30, so that the output module 10 may be simplified for manufacture.

The output module 10 may charge the battery 13 with power supplied by wire from the IT device or from the outside so as to be used, and, at the same time, the output module 10 may charge the battery 13 with power supplied wirelessly from the IT device 30 or from the outside so as to be used.

Furthermore, the output module 10 may be provided with a rectifier for rectifying AC power supplied from the outside into DC power and for supplying the DC power to the output module 10 instead of the battery 13.

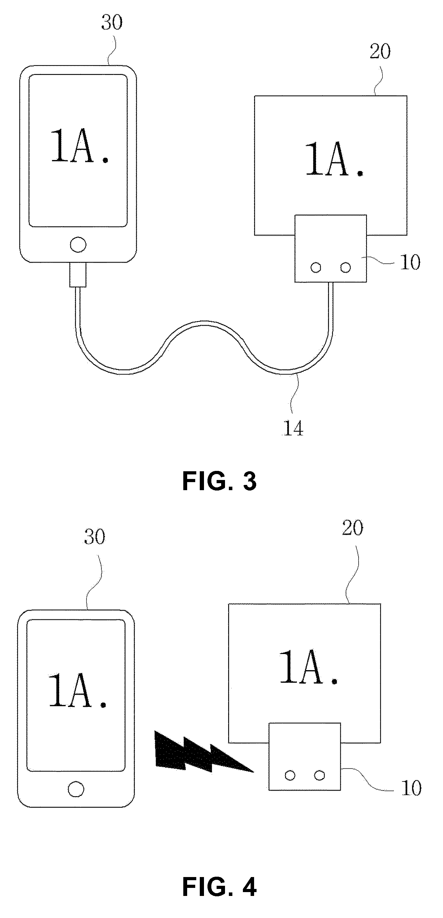

Figs. 3 and 4 are conceptual diagrams illustrating a printing operation using digital paper according to an embodiment of the present invention, and Fig. 5 is an image illustrating an actual printing operation using digital paper according to an embodiment of the present invention.

As illustrated in Figs. 3 to 5, information provided from the IT device 30 by wire (Fig. 3) or wirelessly (Fig. 4) via the output module 10 may be, in color or black and white, output to and printed on the digital paper 20 connected to the output module 10 so that the digital paper 20 may be used like paper.

Here, an output size may vary with a size of the digital paper 20, and an output image may be stored semi-permanently, but the IT device 30 may give instructions to erase output information so that new information may be output and printed. Fig. 6 is a diagram illustrating a TFT backplane layout and a TFT of the digital paper of Fig. 5.

A method for forming an image pattern on the digital paper 20 includes a segmentation method and a TFT driving method, and the digital paper 20 should be provided with a backplane to form an image pattern.

The right-side image of Fig. 6 shows a magnified part of a layout of a backplane 21 employing the TFT driving method, and the left-side diagram is a magnified view of a TFT 22 of the TFT backplane 21.

That is, the TFT transistor 22 includes a switching transistor Q1 of which a gate and a drain are connected to a scan electrode and a data electrode arranged so as to intersect and face each other and a driving transistor Q2 of which a gate is connected to the source of the switching transistor Q1, of which a drain is connected to the source of the switching transistor Q1 via a capacitor, and of which a source is connected to a light-emitting diode.

Furthermore, although not illustrated, a contact electrode is disposed at one side of the TFT backplane 21 so as to contact the contact electrode 12 of the output module 10 to receive data and transfer the data to the scan electrode and the data electrode.

A digital paper manufacturing method according to an embodiment of the present invention includes a step of manufacturing the TFT backplane 21 on a paper or plastic substrate and a step of laminating, on the TFT backplane 21, electrophoretic ink (E-ink) or an electrochromic display or an organic light-emitting diode (OLED) 23. The TFT backplane 21 may be manufactured using a photolithography process or a printing process.

### <TFT Backplane Manufacture>

A TFT backplane manufacturing technology is important for manufacturing digital paper.

A first method for manufacturing a TFT backplane is based on a photolithography technique for producing an amorphous silicon (Si) TFT backplane of a conventional display manufacturing process, so that a wiring, an electrode, a dielectric, and a semiconductor are formed on a paper or plastic substrate through low-temperature deposition and etching.

Here, during this process, overlap between plastic films or sheets of paper are controlled while moving the plastic films or sheets of paper from roll to roll in a stop-and-go manner.

In the stop-and-go manner, a degree of overlap precision for each layer is maintained at a level of 1 µm.

The TFT backplane structure is controlled by maintaining the layout shape illustrated in Fig. 6 as an example. Here, for the definition of digital paper, a pixel size can be controlled from 100 to 20,000.

When electrophoretic ink or an electrochromic display is used for output, mobility (µ) of at least 0.1 cm²/Vs and an on/off ratio of at least 50,000 are sufficient as characteristics of the TFT used in the TFT backplane.

Such TFT characteristics may be achieved using a low-priced organic single-molecule semiconductor, an organic polymer semiconductor, an inorganic oxide semiconductor, and a single-walled carbon nanotube.

Fig. 7 is a diagram illustrating a printing process for manufacturing a TFT backplane during a manufacturing process of digital paper.

A second method for manufacturing a TFT backplane is based on various roll-to-roll (R2R) printing methods so that TFT backplanes may be mass-produced at a low cost.

An offset, gravure, reverse offset, inkjet, or flexo printing method may be used as the R2R printing method, but the R2R gravure method illustrated in Fig. 7 may be suitable for controlling a producing rate and printability.

When R2R printing is performed, a plastic film or paper may be used as a substrate for TFT backplane printing. Here, conductive ink, dielectric ink, and semiconductor ink are manufactured and used in consideration of surficial wetting.

Silver nanoparticle-based ink is mainly used as the conductive ink, but conductive ink of copper or graphite may also be used.

Regarding the dielectric ink, various types of dielectric ink may be manufactured. However, in the present invention, ink with a permittivity (ε) of at least 10 is advantageous for improving production yield.

The semiconductor ink may be manufactured using various polymers or organic single molecules and single-walled carbon nanotubes.

Here, a high-mobility single-walled carbon nanotube is preferably used for manufacturing ink in order to increase a printing output rate.

Although the R2R printing method has been described, the TFT backplane may also be manufactured using a roll-to-plate (R2P) printing method.

After the TFT backplane is manufactured in this manner, the contact electrode (not shown) that contacts the contact electrode 12 of the output module 10 is formed through etching or printing with a micro line width by using conductive ink.

That is, a lower layer of the contact electrode is formed by etching a silver, copper or aluminum thin film so that the output module smoothly contacts thereto, and an upper layer of the contact electrode is treated with graphite so as to improve abrasion resistance.

Furthermore, the lower layer of the contact electrode may be printed using silver, copper or aluminum ink, and the upper layer of the contact electrode may be printed with graphite ink. Here, this printing may be performed using an inkjet, R2R gravure, R2P gravure, R2R offset, R2P offset, screen, or rotary screen printing technique.

The TFT backplane may also be manufactured using a deposition or micro contact printing technique without using the photolithography or R2R printing technique or using the photolithography and R2R printing techniques in combination.

Fig. 8 is a diagram illustrating a laminating process for manufacturing digital paper during a digital paper manufacturing process.

As illustrated in Fig. 8, the TFT backplane 21 of Fig. 7 manufactured as a roll and the electrophoretic ink, the electrochromic display, or the OLED 23 are laminated to each other through an R2R continuous process so as to finally obtain low-priced digital paper 20.

When the above-mentioned R2R laminating is performed, the degree of overlap precision may be controlled to be up to ±10 µm on the basis of camera control.

Laminating of 1000 pixels or more which requires a higher degree of overlap precision may be performed in such a manner that one sheet of a TFT backplane and, for example, one sheet of E-ink are overlapped by about ±1 µm.

An adhesive material used for the laminating includes thermosetting or UV-curable epoxy resin or cyanate-based resin.

Although the preferred embodiment of the present invention has been described, the present invention is not limited thereto and can be variously modified within the scope of the claims, the detailed description of the invention, and the accompanying drawings, and it would be obvious that such a modification also falls within the scope of the present invention.

## Claims

1. A printing system using digital paper, the printing system comprising:
digital paper enabling printing thereon;
an information technology (IT) device configured to transmit, by wire or wirelessly, a command for printing information which is stored therein or being processed and the information to be printed; and
an output module provided with a contact electrode for transmitting data to the digital paper and configured to receive, by wire or wirelessly, a printing command and the information to be printed transmitted from the IT device, convert the information to be printed into an image to be printed, and output the image to be printed to the digital paper.

2. The printing system of claim 1, wherein the IT device transmits, to the output module, the printing command and the information to be printed using wireless near field communication (NFC).

3. The printing system of claim 1, wherein the output module is shaped like a clip or tongs so that the digital paper is not moved when printing is performed through the digital paper.

4. The printing system of claim 3, wherein tongs parts of the output module face other so that center parts of the tongs parts are outwardly curved and end portions of the tongs parts are opened or closed.

5. The printing system of claim 1, wherein the output module is provided with a secondary battery charged with voltage by wire or wirelessly from the IT device or an external device so as to supply the voltage to the output module.

6. The printing system of claim 1, wherein the output module is provided with a rectifier for rectifying power supplied from the outside and for supplying rectified power to the output module.

7. The printing system of claim 1, wherein the digital paper comprises:
a thin film transistor (TFT) backplane disposed on a paper or plastic substrate; and
electrophoretic ink (E-ink), an electrochromic display, or an organic light-emitting diode (OLED) laminated to the TFT backplane.

8. The printing system of claim 7, wherein the TFT backplane has a size of 100 to 10,000 pixels.

9. A method for manufacturing digital paper, the method comprising the steps of:
(a) forming, on a paper or plastic substrate, a thin film transistor (TFT) backplane with a size of 100 to 10,000 pixels; and
(b) laminating the TFT backplane to electrophoretic ink (E-ink), an electrochromic display, or an organic light-emitting diode (OLED) through an roll-to-roll continuous process.

10. The method of claim 9, wherein, in the step (a), the TFT backplane is formed using a photolithography process or a deposition process.

11. The method of claim 9, wherein, in the step (a), the TFT backplane is formed using a photolithography process and a printing process in combination.

12. The method of claim 9, wherein, in the step (a), the TFT backplane is formed using a printing process.

13. The method of claim 11 or 12, wherein the printing process uses at least one of printing techniques of inkjet, roll-to-roll (R2R) gravure, R2R offset, R2R reverse offset, R2R gravure offset, roll-to-plate (R2P) gravure, R2P offset, R2P reverse offset, and R2P gravure offset.

14. The method of claim 11 or 12, wherein the printing process uses an R2R gravure printing technique.

15. The method of claim 11 or 12, wherein ink used for the printing process is conductive ink, dielectric ink, or semiconductor ink.

16. The method of claim 9, wherein, in the step (a), the TFT backplane is formed using a micro contact printing technique.

17. The method of claim 9, wherein, in the step (a), the TFT backplane is formed using a photolithography process, a printing process, and a micro contact printing process in combination.

18. The method of claim 9, wherein, in the step (a), a contact electrode for exchanging data with the outside is formed at the TFT backplane, wherein a lower layer of the contact electrode is formed by etching a silver, copper or aluminum thin film and an upper layer of the contact electrode is treated with graphite.

19. The method of claim 9, wherein, in the step (a), a contact electrode for exchanging data with the outside is formed at the TFT backplane, wherein a lower layer of the contact electrode is printed using silver, copper or aluminum ink and an upper layer of the contact electrode is printed with graphite ink.

20. The method of claim 19, wherein, when the contact electrode is formed, any one of printing techniques of inkjet, R2R gravure, R2P gravure, R2R offset, R2P offset, screen, and rotary screen is used.

21. The method of claim 9, wherein, in the step (b), an adhesive material used for the laminating is thermosetting or UV-curable epoxy resin or cyanate-based resin.

22. The method of claim 9, wherein, in the step (b), the laminating is performed such that one sheet of the TFT backplane and one sheet of the E-ink are overlapped by 1 µm.
